# EUROPEAN PATENT APPLICATION

(11) **EP 3 203 135 A1**
(43) Date of publication of application: **09.08.2017**
(21) Application number: 15847191.2
(22) Date of filing: 30.09.2015
(51) Int. Cl.: F21K 9/00, F21S 2/00, F21V 19/00, H01L 33/00, F21Y 115/10

(54) **LIGHT IRRADIATION DEVICE**

(30) Priority: 01.10.2014 JP 2014202976
(71) Applicant: CCS Inc., Kyoto-shi, Kyoto 602-8011 (JP)
(72) Inventor: OSAWA, Takashi, Kyoto-shi Kyoto 602-8011 (JP)
(74) Representative: Müller Hoffmann & Partner
(86) International application number: PCT/JP2015/077682
(87) International publication number: WO 2016/052594

(57) **Abstract**

The present invention is provided with a first substrate 11 in which a light source body disposition region 11 a, where a first light source body 21 is disposed, and an intermediate region 11b, where a through-hole 41 or notch 42 is provided, are formed alternately in a circumferential direction, and which is configured, due to the curving or bending of the intermediate region 11b in the thickness direction, to form a cylindrical shape of which the internal diameter gradually expands. A second light source body 22 is disposed at the back of the intermediate region 11b, and a configuration is adopted whereby an object W to be inspected is irradiated with an inspection light from said light source body 22 via the through-hole 41 or the notch 42.

## Description

### [Technical Field]

The present invention relates to a light irradiation device in which a plurality of surface-mounted LED or LED elements are mounted on a cylindrical or partially cylindrical substrate.

### [Technical Background]

A ring-shaped inspection illumination device such as that described, for example, in Patent Document 1 is known as an example of the aforementioned light irradiation device. This illumination device is manufactured in a circular cylinder shape whose internal diameter gradually expands by soldering a plurality of shell LED onto a flexible substrate that is formed in a partial toroidal belt shape when laid out flat, and then bending the flexible substrate in the thickness direction thereof into a round shape such that edges of the two ends thereof are mutually facing each other.

According to this manufacturing method, after required components such as LED have been soldered onto the illumination device while the illumination device is lying flat, because the outline of the illumination device can then be completed simply by bending the illumination device into a round shape, automation and simplification of the assembly process can be accelerated to the maximum possible degree, and the effect can be obtained that it is possible to precisely set the optical axis of each LED.

In contrast, in recent years, in conjunction with increasingly faster camera shutter speeds and the like, even brighter ring illumination devices are sought, and instead of shell LED, consideration has been given to mounting surface-mounted LED, which have a greater degree of brightness, on a ring illumination device.

However, in reality, problems such as those described below have occurred so that this structure has not yet been achieved.

Namely, in the same way as in a conventional structure, if a flexible substrate is laid out flat and surface-mounted LED are soldered onto this flexible substrate, then the soldered area of the substrate is greatly increased compared to shell LED whose terminals are inserted into through holes and are then soldered. As a consequence, the flexibility of the substrate is lost because of the rigidity of the solder, and the drawback arises that it becomes substantially impossible to bend the substrate into a round shape after the LED have been mounted thereon.

On the other hand, if the disposition density of the surface-mounted LED is reduced in order to secure the flexibility of the substrate, then this tends to cause light to be irradiated unevenly onto an inspection subject (i.e., a work piece), and leads to a reduction in the illumination intensity.

Moreover, consideration may also be given to firstly bending the flexible substrate into a round shape and then mounting the surface-mounted LED thereon, however, it is essentially impossible to do this. The reason is that because the surface-mounted LED are reflow soldered, it is essential that the soldering be performed while the flexible substrate is laid out flat.

### [Documents of the prior art]

### [Patent documents]

[Patent document 1] Japanese Unexamined Patent Application (JP-A) No. 2008-139708

### [Disclosure of the Invention]

### [Problems to be Solved by the Invention]

The present invention was conceived in order to solve all of the above-described drawbacks, and it is an intended objective thereof to provide a light irradiation device in which the flexibility of the flexible substrate is not lost, and that, in essence, enables surface-mounted LED to be mounted densely so that a substantial increase in brightness can be achieved effortlessly, and that can be manufactured easily.

### [Means for Solving the Problem]

Namely, a light irradiation device according to the present invention is characterized in having the following essential components.

### a) First substrate

In this first substrate, light source body disposition regions and intermediate regions are formed alternately in a circumferential direction, and the first substrate is formed in a cylindrical shape or partially cylindrical shape as a result of these intermediate regions being curved or bent in a thickness direction. Note that the 'cylindrical shape' referred to here includes not only cylinders having a uniform internal diameter, but also cone-shaped cylinders whose internal diameter becomes gradually larger or gradually smaller. In addition, this 'cylindrical shape is not restricted to cylinders having a circular cross-section, but includes cylinders having polygonal or elliptical cross-sections.

### b) Plurality of first light source bodies

The first light source bodies are surface-mounted LED or LED elements, and are disposed in the light source body disposition regions such that they irradiate light onto a predetermined subject.

### c) Plurality of second light source bodies

The second light source bodies are surface-mounted LED or LED elements, and are disposed at the rear of the intermediate regions such that they irradiate light onto the subject via through holes or notches that are provided in the relevant intermediate regions.

Accordingly, if this type of structure is employed, because surface-mounted LED or LED elements are used as the light source bodies, compared to shell LED, a greater degree of brightness can be achieved.

Moreover, even if the first substrate is laid out flat and the first light source bodies are fixed by, for example, reflow soldering to the light source body disposition regions thereof, sufficiently wide intermediate regions are formed between the light source body disposition regions so that by bending these intermediate regions, the first substrate can be easily formed into a cylindrical shape or a partially cylindrical shape. Accordingly, the manufacturing process can be simplified, and because no excessive bending force is applied to the light source body disposition regions, malfunctions such as the soldered portions of the light source bodies peeling away are also prevented.

Furthermore, because the light source bodies are provided in a two-stage disposition structure in which through holes or notches are provided in the intermediate regions and the second light source bodies emit light from the rear of the intermediate regions, when viewed from the position of the subject, the disposition density of the light source bodies (i.e., both the first light source bodies and the second light source bodies) can be increased, and light is not irradiated unevenly onto the subject. Note that, in this manner, if the distance from the subject to the first light source body is different from distance to the second light source body, then it may be thought that irradiation unevenness is caused by differences between the irradiation intensities of the first light source body and the second light source body, however, because each LED in this type of light irradiation device is formed such that light is irradiated so as to surround the subject, irradiation unevenness is due mainly to the disposition angle pitch of the LED and on the light distribution direction of the LED, and differences in the distance have substantially no effect on irradiation unevenness. The present inventors noticed this fact for the first time and, as a consequence, were able to achieve the present invention.

In order to enable the second light source body to be easily assembled, it is preferable for the following essential components to be further provided.

### d) Second substrate

The second substrate is disposed on the outer side of the first substrate and, by being curved or bent in the thickness direction, is formed in a cylindrical shape or partially cylindrical shape whose internal diameter is either uniform or becomes gradually larger. The second light source bodies are disposed on this second substrate.

An example of a casing that optimally holds the first substrate and the second substrate is a casing that is formed in a toroidal or partially toroidal shape, and whose inner circumferential surface is formed in a two-stage configuration having a front surface that is used for mounting the first substrate, and a rear surface that is used for mounting the second substrate.

In order to increase the disposition density of the light source bodies, it is preferable for a plurality of the first light source bodies to be provided in a row extending in an orthogonal direction relative to the circumferential direction in one light source body disposition region, and for a plurality of the second light source bodies to be provided in a row extending in an orthogonal direction relative to the circumferential direction at the rear of one intermediate region.

Furthermore, the same type of effects are also demonstrated when a light irradiation device having the following essential components is provided.

### a) Substrate

In this substrate, light source body disposition regions and intermediate regions are formed alternately, and the substrate is formed in a cylindrical shape or partially cylindrical shape as a result of these intermediate regions being curved or bent in the thickness direction.

The distance from a central axis of this substrate to an n^{th} (wherein n is an odd number greater than 1) light source body disposition region is shorter than a distance to an n + 1^{th} light source body disposition region, and the n^{th} light source body disposition region is connected to the n + 1^{th} light source body disposition region via the intermediate region which is curved or bent in a thickness direction.

### b) Plurality of first light source bodies

The first light source bodies are surface-mounted LED or LED elements, and are disposed in the n^{th} light source body disposition region such that they irradiate light onto a predetermined subject.

### c) Plurality of second light source bodies

The second light source bodies are surface-mounted LED or LED elements, and are disposed in the n + 1^{th} light source body disposition region such that they irradiate light onto the subject through a gap between the n^{th} and an n + 2^{th} light source body disposition region.

### [Effects of the Invention]

According to the above-described present invention, it is possible to provide a light irradiation device in which the flexibility of the flexible substrate is not lost, and that, in essence, enables surface-mounted LED and LED elements to be mounted densely so that a substantial increase in brightness can be achieved effortlessly, and that can be manufactured easily.

### [Brief description of the drawings]

[FIG. 1] FIG. 1 is an overall perspective view of a light irradiation device according to a first embodiment of the present invention.
[FIG. 2] FIG. 2 is a vertical cross-sectional view of the light irradiation device according to the same embodiment.
[FIG. 3] FIG. 3 is an underside view of the light irradiation device according to the same embodiment.
[FIG. 4] FIG. 4 is a perspective view showing an assembled first substrate according to the same embodiment.
[FIG. 5] FIG. 5 is a plan view showing the first substrate in a laid-out flat state (i.e., prior to assembly) according to the same embodiment.
[FIG. 6] FIG. 6 is a plan view showing a second substrate in a laid-out flat state (i.e., prior to assembly) according to the same embodiment.
[FIG. 7] FIG. 7 is a perspective view showing an assembled second substrate of the light irradiation device according to the same embodiment.
[FIG. 8] FIG. 8 is an exploded perspective view of the light irradiation device according to the same embodiment.
[FIG. 9] FIG. 9 is a perspective cross-sectional view of a light irradiation device according to a variant example of the same embodiment.

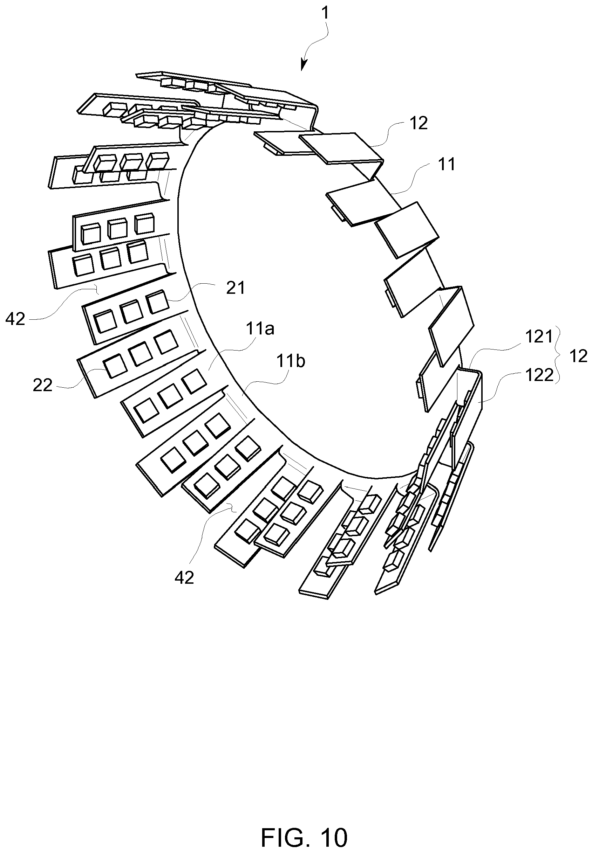

[FIG. 10] FIG. 10 is a perspective view showing an assembled first substrate and second substrate according to a second embodiment of the present invention.
[FIG. 11] FIG. 11 is a perspective view showing an assembled substrate according to a third embodiment of the present invention.

### [Description of the Reference Numerals]

- 100: Light irradiation device
- W: Inspection subject
- 1: Substrate
- 11: First substrate
- 11a: Light source body disposition region
- 11b: Intermediate region
- 12: Second substrate
- 12a: Light source body disposition region
- 12b: Intermediate region
- 21: First light source body
- 22: Second light source body
- 3: Casing
- 31: First casing element
- 32: Second casing element
- 41: Through hole
- 42: Notch
- 1A: Light source body disposition region
- 1B: Intermediate region

### [Best Embodiments for Implementing the Invention]

### [First embodiment]

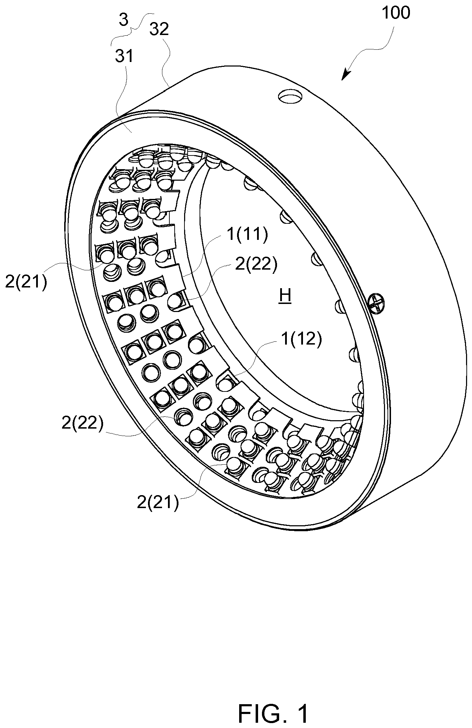

As is shown in FIG. 1 through FIG. 3, a light irradiation device 100 according to the present embodiment is what is known as a ring-type surface inspection light irradiation device that is equipped with a substrate 1 which is formed having a circular cylinder-shaped outline whose internal diameter becomes gradually larger (hereinafter, this is referred to as a truncated hollow cone shape), a plurality of light source bodies 2 which are mounted on an inner circumferential surface of the substrate 1 and irradiate inspection light diagonally onto an inspection subject W from around a periphery of the inspection subject W, and a casing 3 having an observation hole H that is used to inspect the inspection subject W from above via a camera or via the naked eye provided in the center thereof, and that holds, via an inner circumference of the observation hole H, the substrate 1 on which the light source bodies 2 are mounted.

The respective portions will now be described.

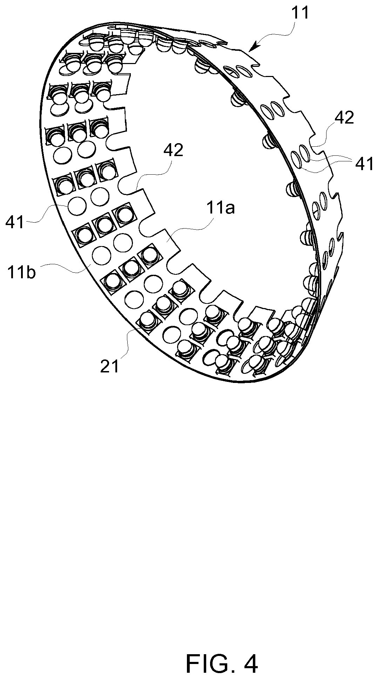

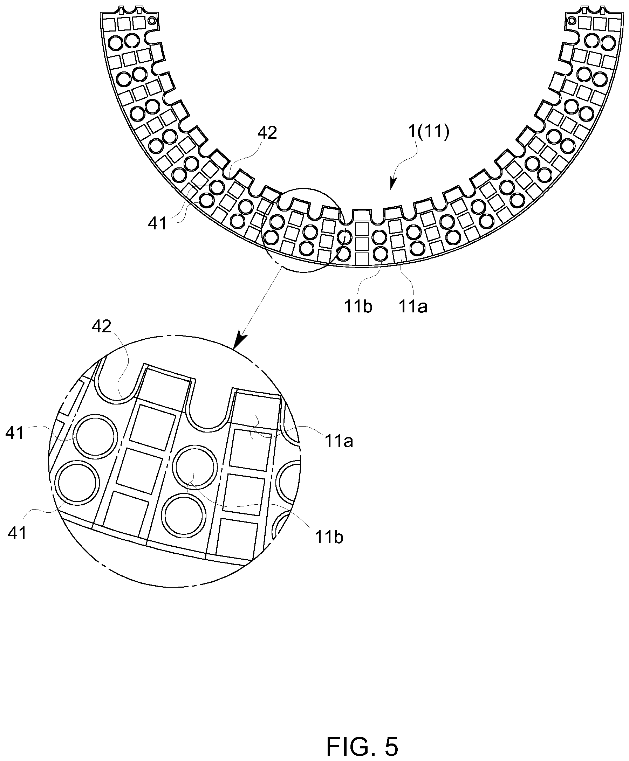

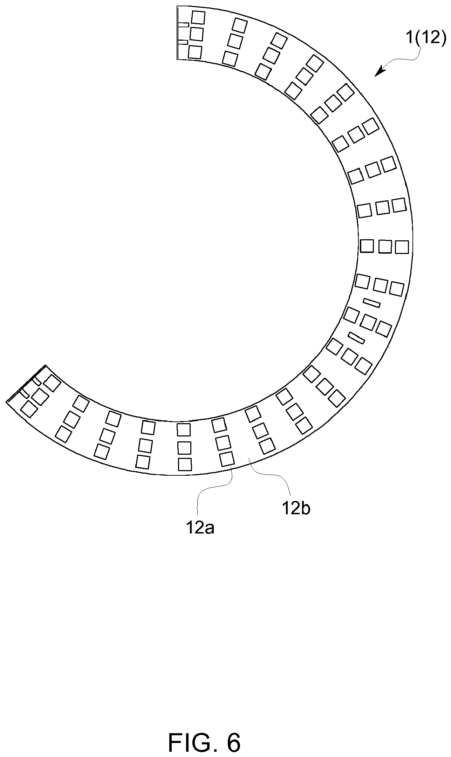

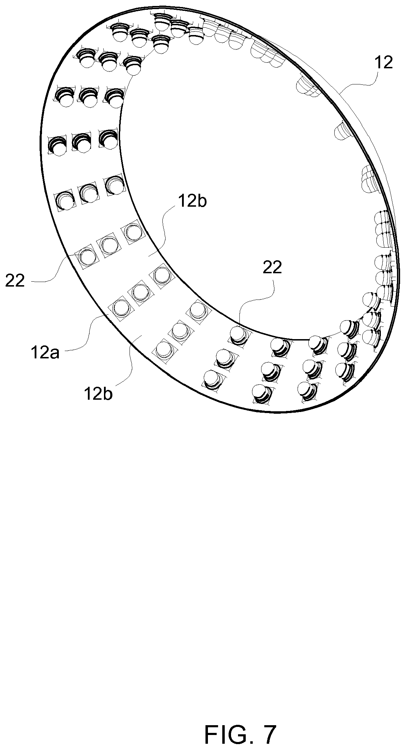

The substrate 1 is what is known as a flexible wiring substrate on which wiring is pre-printed, and that is able to be bent in the thickness direction thereof, and that, as is shown in FIG. 5 and FIG. 6, is formed in a partial toroidal belt shape when laid out flat. By then rolling the substrate 1 in the thickness direction such that end edges thereof are facing each other, as is shown in FIG. 4 and FIG. 7, the substrate 1 is formed in a truncated hollow circular cone shape.

As is shown in FIG. 1 and the like, the light source bodies 2 are what are known as surface-mounted LED that are formed by mounting LED elements on a rectangular (i.e., square) plate-shaped package. Note that the LED in this embodiment are also equipped with a condensing lens that is provided on the package.

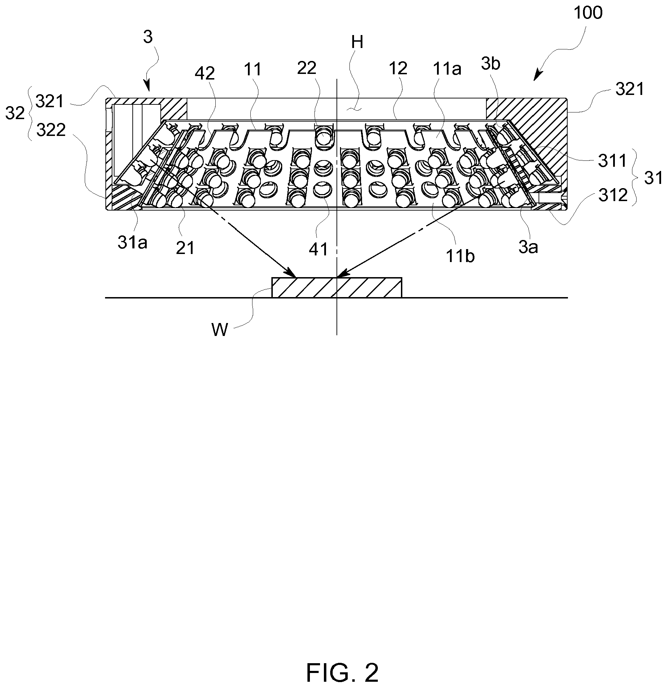

Accordingly, in this embodiment, as is shown in FIG. 1 and FIG. 2, two substrates 1 having mutually different diameters are provided coaxially on an inner side and an outer side of each other so as to form the aforementioned truncated hollow circular cone shaped-substrate 1. Note that, in the following description, when it is necessary to distinguish between these two substrates 1, the inner-side substrate 1 is referred to as a first substrate 11, while the outer-side substrate 1 is referred to as a second substrate 12. The light source bodies 2 mounted on the first substrate 11 are referred to as first light source bodies 21, while the light source bodies 2 mounted on the second substrate 12 are referred to as second light source bodies 22.

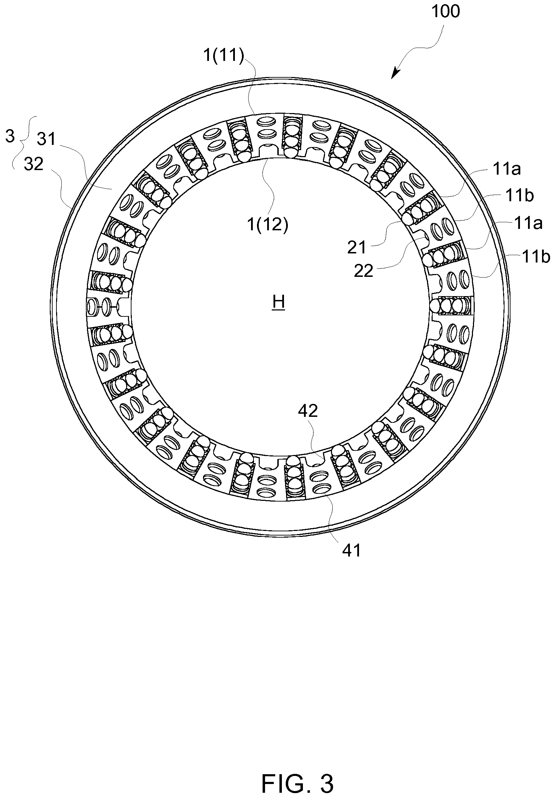

As is shown in FIG. 3 through FIG. 5, in the first substrate 11, light source body disposition regions 11 a on which the first light source bodies 21 are mounted are formed alternately in a circumferential direction with intermediate regions 11b on which the first light source bodies 21 are not mounted.

A plurality (in this example, three) of the first light source bodies 21 are arranged in a single row (or in a plurality of rows) extending in a perpendicular direction relative to the circumferential direction in each of the light source body disposition regions 11 a.

In the same way, as is shown in FIG. 6 and FIG. 7, in the second substrate 12 as well, light source body disposition regions 12a on which the second light source bodies 22 are mounted are formed alternately in the circumferential direction with intermediate regions 12b on which the second light source bodies 22 are not mounted. A plurality (in this example, three) of the second light source bodies 22 are arranged in a single row (or in a plurality of rows) extending in a perpendicular direction relative to the circumferential direction in each of the light source body disposition regions 12a.

A plurality of (in this example, three) through holes 41 and notches 42 are formed in a single row extending in a straight line in a perpendicular direction relative to the circumferential direction in each intermediate region 11b of the first substrate 11. Here, for example, two through holes 41 are formed on the outer circumferential side, and the remaining hole is a notch 42 that is open at the inner circumferential edge. The through holes 41 and notch 42 are used to transmit inspection light from the second light source body 22 that is disposed on the outer side (i.e., at the rear side) thereof.

Note that the through holes 41 and notch 42 are not provided in the intermediate regions 12b of the second substrate 12. Moreover, in the first substrate 11, the first light source bodies 21 are provided in a zigzag positional relationship with the through holes 41 and notches 42.

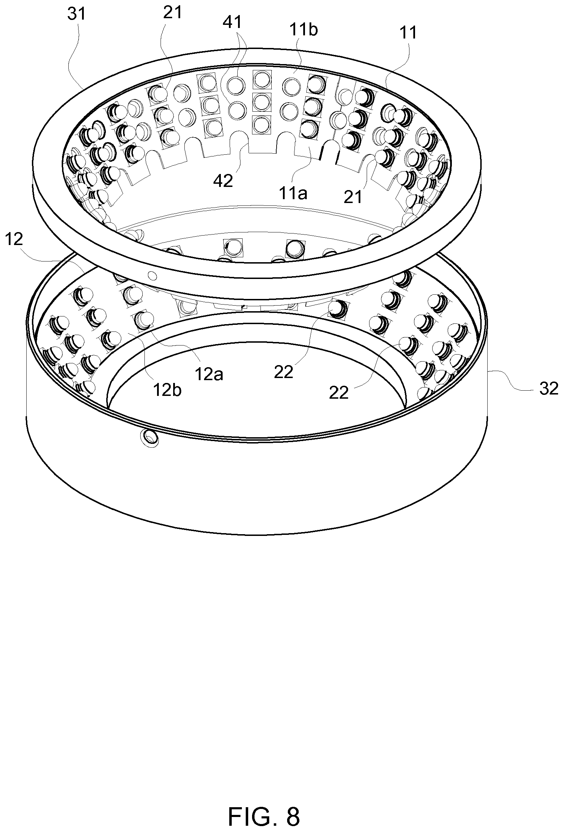

As is shown in FIG. 1 through FIG. 3 and in FIG. 8, the casing 3 holds the first substrate 11 at the inner circumference thereof, and holds the second substrate 12 at predetermined positions on the outer side thereof in such a way that the central axes of the two substrates coincide with each other. The casing 3 is formed such that, in addition to inspection light from the first light source bodies 21 that are mounted on an inner circumferential surface of the first substrate 11, inspection light from the second light source bodies 22 that are mounted on an inner circumferential surface of the second substrate 12 that is located to the rear of the first substrate 11 is also transmitted through the through holes 41 and notches 42 that are provided in the first substrate 11, and is irradiated diagonally onto the inspection subject W which has been placed on the large-diameter side of the observation hole H from around the periphery thereof Note that, here, the angle of inclination of the inner circumferential surface of the second substrate 12 relative to the central axis is smaller than that of the first substrate 11 and, as is shown in FIG. 2, the inspection light from the second light source bodies 22 is irradiated somewhat further to the outer side than the inspection light from the first light source bodies 21 so that, as a result, the uniformity of the irradiation of inspection light onto the inspection subject W is improved.

The structure of this casing 3 will now be described in greater detail.

As is shown in FIG. 2 and FIG. 8 and the like, the casing 3 is a metal casing that is made by joining together in the axial direction a first casing element 31 that holds the first substrate 11 and a second casing element 32 that holds the second substrate 12.

The first casing element 31 is formed by a first supporting body 311 that is formed in a truncated hollow cone shape, and a brim-shaped body 312 that is formed in a toroidal shape integrally with the first supporting body 311 and extends towards the outer side from a large-diameter aperture edge of the first supporting body 311. Through holes 31 a are formed in the first supporting body 311 at positions that correspond to the through holes 41 in the first substrate 11. Note that the first supporting body 311 does not have sufficient width to reach a position that corresponds to the notches 42 in the first substrate 11, so that the notches 42 in the first substrate 11 are not covered by the first supporting body 311.

In addition, the through holes 41 in the first substrate 11 are positioned so as to coincide with the through holes 31a in the first supporting body 311, and the first substrate 11 is adhered via a thin viscoelastic sheet (not shown in the drawings) having sufficient insulation properties and thermal conductivity to a first truncated cone-shaped concave surface 3 a that is formed on an inner circumferential surface of the first supporting body 311.

The second casing element 32 is equipped with a circular cylinder-shaped second supporting body 321 having a central hole whose inner diameter becomes gradually wider, and a thin circumferential wall body 322 that is integral with the second supporting body 321 and extends in an axial direction from an outer edge thereof. In addition, the second substrate 12 is adhered via a thin viscoelastic sheet having sufficient insulation properties and thermal conductivity to a second truncated cone-shaped concave surface 3b that is formed on an inner circumferential surface of the second supporting body 321. Meanwhile, the circumferential wall body 322 is fitted tightly from the outside around the brim-shaped body 312 of the first casing element 31, and by fixing this circumferential wall body 322 to the brim-shaped body 312 by for example, screwing the circumferential wall body 322 to a side wall surface thereof, the first casing element 31 and the second casing element 32 are joined together.

Next, a method of assembling the above-described light irradiation device 100 will be described.

Firstly, the respective substrates 11 and 12, which are formed in a partially toroidal shape, are laid out flat, and the light source bodies 21 and 22 are mounted thereon. The substrates 11 and 12 and light source bodies 21 and 22 are then placed inside a reflow furnace and are soldered.

Next, the respective substrates 11 and 12 are curved in the thickness direction thereof such that end edges thereof are facing each other so as to form a truncated hollow cone shape. At this time, the light source body disposition regions 11 a and 12a of the respective substrates 11 and 12 remain essentially unbent due to the solder, and it is mainly the intermediate regions 11b and 12b that are bent. Accordingly, if the shape of the substrates 11 and 12 were to be described more accurately, they are formed in a truncated hollow cone-shaped outline by providing flat surfaces alternatingly with curved surfaces.

Next, the outer circumferential surface of the first substrate 11 is adhered via a viscoelastic sheet to the first truncated cone-shaped concave surface 3a that is formed in the first casing element 31. At this time, the through holes 41 in the first substrate 11 are positioned such that they coincide with the through holes 31a provided in the first supporting body 311.

In contrast to this, the second substrate 12 is adhered via a viscoelastic sheet to the second truncated cone-shaped concave surface 3b that is formed in the second casing element 32. At this time, when the casing elements 31 and 32 are joined together, which is the next step, the respective second light source bodies 22 that are mounted on the inner circumferential surface of the second substrate 12 are positioned such that they face the through holes 41 and notches 42 in the first substrate 11 (and also the through holes 31a in the first supporting body 311).

Lastly, the circumferential wall body 322 of the second casing element 32 is fitted around the outside of the first casing element 31 from the narrow aperture side thereof, and by screwing the circumferential wall body 322 of the second casing element 32 to the brim-shaped body 312 of the first casing element 31, the first casing element 31 and the second casing element 32 are joined together.

According to the light irradiation device 100 having the above-described structure, the following effects are demonstrated.

Because surface-mounted LED or LED elements are used as the light source bodies 2, greater brightness can be achieved than when shell LED are used.

Moreover, because the light source bodies 2 are reflow soldered to the respective substrates 11 and 12 when these have been laid out flat, they can be soldered easily and effortlessly. In addition, after this soldering, in the step in which the substrates 11 and 12 are formed in a truncated hollow cone shape by curving the end edges thereof such that they face each other, although the light source body disposition regions 11 a and 12a where the light source bodies 2 are disposed remain substantially unbent, the intermediate regions 11b and 12b are formed between the light source body disposition regions 11 a and 12a and these intermediate regions 11b and 12b do bend. As a result, the substrates 11 and 12 can be easily formed into a truncated hollow cone shape, and because no excessive bending force or residual stress is applied to the light source body disposition regions 11 a and 12a, it is possible to reliably prevent the soldered portions from peeling away.

In contrast, because the light source bodies 21 and 22 have a two-stage disposition structure in which the through holes 41 and notches 42 are formed in the intermediate regions 11b, and the second light source bodies 22 emit inspection light from the rear thereof, when viewed from the position of the inspection subject W, the disposition density of the light source bodies 2 (i.e., both the first light source bodies 21 and the second light source bodies 22) can be increased, and there is no unevenness in the light irradiation onto the inspection subject W.

Note that, in this manner, if the distance from the inspection subject W to the first light source body 21 is different from distance to the second light source body 22, then it may be thought that irradiation unevenness is caused by differences between the irradiation intensities of the first light source body 21 and the second light source body 22, however, because each light source body 2 in this type of light irradiation device 100 is formed such that inspection light is irradiated so as to surround the inspection subject W, irradiation unevenness is due mainly on the disposition angle pitch of the light source bodies 2 and on the light distribution direction of the light source bodies 2, and differences in the distance have substantially no effect on irradiation unevenness. The effect of this is particularly significant in surface inspection applications.

In addition, in this embodiment, because the respective substrates 11 and 12 are thermally adhered tightly to the metal casing 3, the light source bodies 3 can be cooled effortlessly via the casing 3.

Next, a variant example of the present embodiment will be described.

For example, although not shown in the drawings, it is also possible to form a pseudo-dome type of light irradiation device in which a plurality of ring-type light irradiation devices having different outer diameters and light distribution angles are stacked in the axial direction (more specifically, such that, the closer to the upper stage, the smaller the outer diameter becomes and the more vertical the light distribution angle becomes).

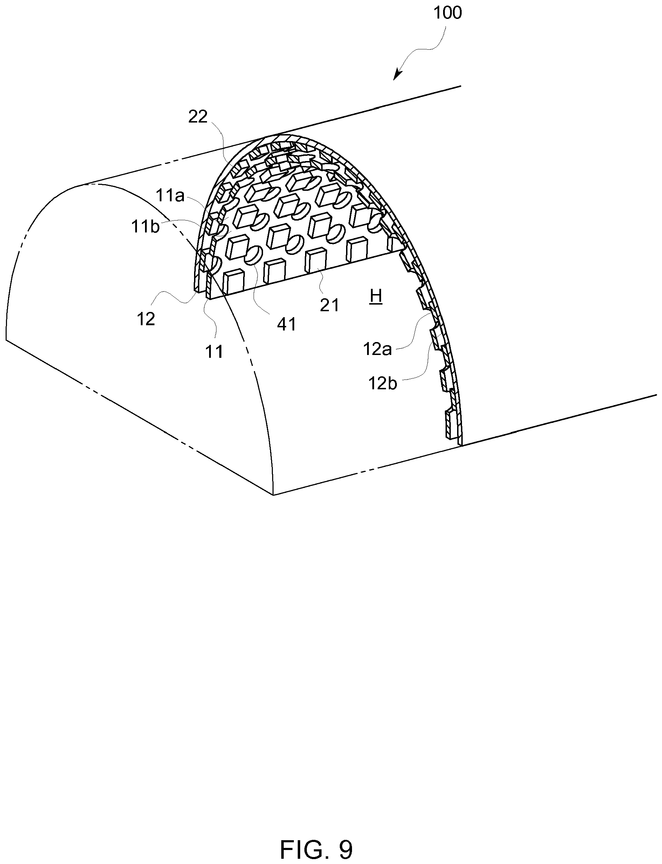

Moreover, it is also possible to apply the present invention, for example, to a semi-cylindrical light irradiation device 100, such as that shown in FIG. 9, that is used for an elongated inspection subject W.

In the case of this semi-cylindrical light irradiation device 100, for example, the first light source bodies 21 and the second light source bodies 22 are mounted via the substrates 11 and 12 respectively on a first semi-cylindrical concave surface that is provided in the casing, and a second semi-cylindrical concave surface that is provided on the outer side of the first semi-cylindrical concave surface. The first substrate 11 and the second substrate 12 are each formed in a rectangular shape, and are formed such that the light source body disposition regions 11a and 12a appear alternatingly with the intermediate regions 11b and 12b in a horizontal direction. In the same way as in the above-described embodiment, the through holes 41 are provided in the intermediate regions 11b of the first substrate 11, and inspection light from the second light source bodies 22 is transmitted through the through holes 41 and is irradiated onto the inspection subject W.

### [Second embodiment]

In this second embodiment, the description concentrates mainly on the shape of the substrate 1, and a description of the casing is omitted.

In this embodiment, as is shown in FIG. 1, the first substrate 11, which holds the first light source bodies 21, and the second substrate 12, which holds the second light source bodies 22, are combined as a continuous integrated body to form a single substrate 1.

More specifically, a structure is employed in which notches 42 that extend outwards in a radial direction from the small diameter-side circumferential edge of the first substrate 11 are provided in the intermediate regions 11b of the first substrate 11, and the respective light source body disposition regions 11a of the first substrate 11 are formed as short strips. The respective light source body disposition regions 11 a are firmly held in a first truncated cone-shaped concave surface that is formed in a casing (not shown).

The second substrate 12 is formed by base end portions 121 that extend from the intermediate regions 11b of the first substrate 11 while either curving or being bent backwards, and by mounting portions 122 that continue on from the base end portions 121 and are formed in the shape of short strips on which the second light source bodies 22 are mounted. The mounting portions 122 are firmly held in a second truncated cone-shaped concave surface that is formed in the casing 3 (not shown). In the same way as in the above-described first embodiment, this second truncated cone-shaped concave surface is formed on the outer side of the first truncated cone-shaped concave surface.

According to this structure, in addition to the inspection light from the first light source bodies 21 that are mounted on the inner circumferential surface of the first substrate 11, inspection light from the second light source bodies 22 that are mounted on the inner circumferential surface of the second substrate 12 located at the back of the first substrate, is transmitted through the notches 42 provided in the first substrate 11, and is irradiated diagonally onto the inspection subject W that has been set up on the large diameter-side of the observation hole H from around the periphery thereof.

According to this second embodiment as well, essentially the same type of effects can be achieved as from the above-described first embodiment. Furthermore, this embodiment has the advantage that only one substrate needs to be provided.

Note that in the same way as in the above-described first embodiment, the structure of the light irradiation device according to the present embodiment may also be applied to dome-type inspection light irradiation devices and semi-cylindrical inspection light irradiation devices.

### [Third embodiment]

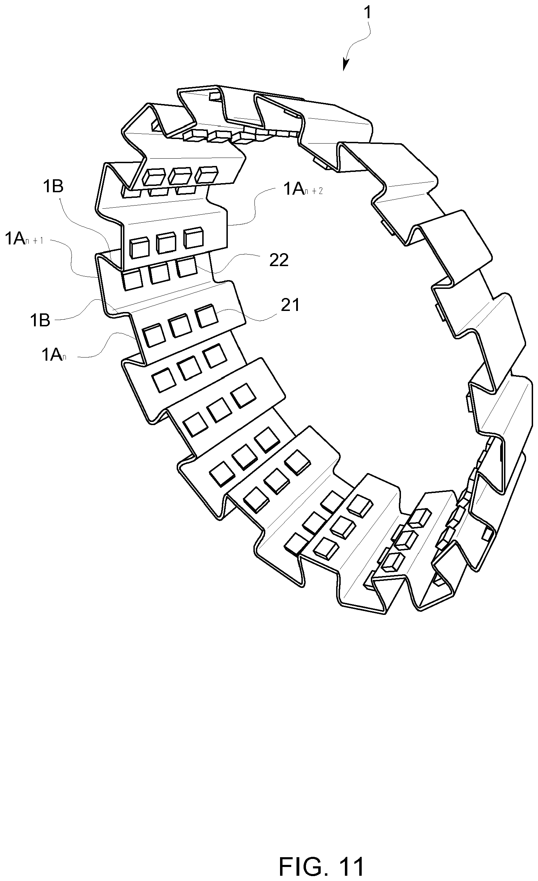

In this embodiment, as is shown in FIG. 11, a structure is employed in which the single substrate 1 holds the first light source bodies 21 and the second light source bodies 22.

This substrate 1 is formed having a partially toroidal belt-shaped outline when laid out flat (not shown in this state), and is formed such that light source body disposition regions 1A alternate with the intermediate regions 1B. In addition, by curving or bending the intermediate regions 1B in the thickness direction such that end edges of the substrate 1 are facing each other, the substrate 1 is formed having a truncated hollow circular cone-shaped outline.

To describe this more specifically, the distance from a central axis of the substrate 1 when this is in a truncated hollow circular cone shape to an n^{th} (wherein n is an odd number greater than 1) light source body disposition region 1Aₙ is shorter than a distance to an n + 1^{th} light source body disposition region 1Aₙ₊₁, and the light source body disposition region 1Aₙ is connected to the light source body disposition region 1Aₙ₊₁ via the intermediate region 1B which is curved or bent in the thickness direction.

The first light source bodies 21 are disposed in the n^{th} light source body disposition region 1Aₙ, and are formed so as to irradiate inspection light onto a predetermined inspection subject W.

The second light source bodies 22 are disposed in the n + 1^{th} light source body disposition region 1Aₙ₊₁, and are formed so as to irradiate inspection light onto a predetermined inspection subject W through the gap between the n^{th} light source body disposition region 1Aₙ and an n + 2^{th} light source body disposition region 1Aₙ₊₂.

According to this third embodiment as well, essentially the same type of effects as in the above-described first and second embodiments can be demonstrated. Furthermore, this embodiment has the advantage that only one substrate 1 needs to be provided.

Note that in the same way as in the above-described first embodiment, the structure of the light irradiation device according to the present embodiment may also be applied to dome-type inspection light irradiation devices and semi-cylindrical inspection light irradiation devices.

Moreover, in each of the above-described embodiments, the light irradiation device according to the present invention is used with light source bodies that are used for surface inspections, however, the present invention is not limited to this and it is also possible, for example, to use devices that emit ultraviolet light for the light source bodies in order to cure ultraviolet curable resin.

In addition to this, if, for example, instead of surface-mounted LED, LED elements themselves are mounted on a substrate, then the same type of effects as those obtained from the present invention can be demonstrated, and it is also possible for various modifications to be made insofar as they do not depart from the spirit or scope of the present invention such as combining together a portion of the above-described embodiments and variant examples thereof.

### [Industrial applicability]

According to the above-described present invention, it is possible to provide a light irradiation device in which the flexibility of the flexible substrate is not lost, and that, in essence, enables surface-mounted LED and LED elements to be mounted densely so that a substantial increase in brightness can be achieved effortlessly, and that can be manufactured easily.

## Claims

1. A light irradiation device is **characterized in** being provided with the following essential components.
a) A first substrate in which light source body disposition regions and intermediate regions are formed alternately in a circumferential direction, and that is formed in a cylindrical shape or partially cylindrical shape whose internal diameter remains uniform or becomes gradually larger as a result of the intermediate regions being curved or bent in a thickness direction,
b) a plurality of first light source bodies in the form of surface-mounted LED or LED elements that are disposed in the light source body disposition regions and irradiate light onto a predetermined subject, and
c) a plurality of second light source bodies in the form of surface-mounted LED or LED elements that are disposed at the rear of the intermediate regions, and irradiate light onto the subject via through holes or notches that are provided in the intermediate regions.

2. The light irradiation device according to claim 1 is **characterized in** being further provided with the following essential components.
d) A second substrate that is disposed on an outer side of the first substrate and on which the second light source bodies are provided, and that, by being curved or bent in the thickness direction, is formed in a cylindrical shape or partially cylindrical shape whose internal diameter is either uniform or becomes gradually larger

3. The light irradiation device according to claim 2 is **characterized in** being further provided with the following essential components.
e) A casing that is formed in a toroidal or partially toroidal shape and to whose inner circumference the first substrate and the second substrate are attached.

4. The light irradiation device according to claim 3 is **characterized in that** the casing is equipped with a first casing element that is formed in a toroidal or partially toroidal shape, and with a second casing element that is formed in a toroidal shape or partially toroidal shape and is coaxially connected to the first casing element, and **in that** the first substrate is attached to an inner circumference of the first casing element, and the second substrate is connected to an inner circumference of the second casing element.

5. The light irradiation device according to claim 1 is **characterized in that**, in one light source body disposition region, a plurality of the first light source bodies are provided in a row extending in an orthogonal direction relative to the circumferential direction, and at the rear of one intermediate region, a plurality of the second light source bodies are provided in a row extending in an orthogonal direction relative to the circumferential direction.

6. A light irradiation device is **characterized in** being provided with the following essential components.
a) A substrate in which light source body disposition regions and intermediate regions are formed alternately, and that is formed in a cylindrical shape or partially cylindrical shape as a result of the intermediate regions being curved or bent in the thickness direction, and in which
a distance from a central axis of the substrate to an n^{th} (wherein n is an odd number greater than 1) light source body disposition region is shorter than a distance to an n + 1^{th} light source body disposition region, and the n^{th} light source body disposition region is connected to the n + 1^{th} light source body disposition region via the intermediate region which is curved or bent in the thickness direction,
b) a plurality of first light source bodies in the form of surface-mounted LED or LED elements that are disposed in the n^{th} light source body disposition region and irradiate light onto a predetermined subject, and
c) a plurality of second light source bodies in the form of surface-mounted LED or LED elements that are disposed in the n + 1^{th} light source body disposition region, and irradiate light onto the subject through a gap between the n^{th} and an n + 2^{th} light source body disposition region.
